(19) Europäisches Patentamt

European Patent Office

Office européen des brevets

(11) Veröffentlichungsnummer: **0 315 799 B1**

(12) **EUROPÄISCHE PATENTSCHRIFT**

(45) Veröffentlichungstag der Patentschrift: **06.05.92**

(21) Anmeldenummer: **88117266.2**

(22) Anmeldetag: **17.10.88**

(51) Int. Cl.⁵: **H05K 13/04**

(54) Vorrichtung und Verfahren zum Bestücken von Leiterplatten mit Bauelementen.

(30) Priorität: **10.11.87 DE 3738152**

(43) Veröffentlichungstag der Anmeldung:
**17.05.89 Patentblatt 89/20**

(45) Bekanntmachung des Hinweises auf die
Patenterteilung:
**06.05.92 Patentblatt 92/19**

(84) Benannte Vertragsstaaten:
**AT CH DE FR GB IT LI SE**

(56) Entgegenhaltungen:
**DE-A- 3 424 323**
**DE-A- 3 532 500**
**GB-A- 2 108 015**

(73) Patentinhaber: **SIEMENS AKTIENGESELL-**
**SCHAFT**
**Wittelsbacherplatz 2**
**W-8000 München 2(DE)**

(72) Erfinder: **Haan, Franz, Dipl.-Ing. FH.**
**Josef-Heid-Strasse 11**
**W-7520 Bruchsal(DE)**
Erfinder: **Hock, Lothar**
**Illigstrasse 17A**
**W-1000 Berlin 49(DE)**

**Beschreibung**

Die Erfindung betrifft eine Vorrichtung zum Bestücken von Leiterplatten mit Bauelementen die mindestens einen drehbaren Mehrfach-Bestückkopf mit mehreren Aufnahmewerkzeugen für Bauelemente aufweist, wobei, deren wesentlicher Einsatz bei der SMD-Technik, speziell bei den zugehörigen Bestückautomaten, angesiedelt ist und ein Verfahren mit einer derartigen Vorrichtung.

Solche Vorrichtungen und deren Anwendungen sind aus DE-A-3 424 323 und aus GB-A-2 108 015 bekannt.

Zum schnellen Bestücken von Leiterplatten mit elektrischen Bauelementen werden sogenannte Bestückautomaten eingesetzt. Die in diesem Bereich gewünschten Zeiteinsparungen bei verschiedenen Bearbeitungsprozessen haben dazu geführt, daß die sogenannte SMD-Technik (Surface Mounted Device) überwiegend eingesetzt wird. Bei dieser ohnehin sehr vorteilhaften und kompakten Bestückung von Leiterplatten werden von verschiedenen Herstellern Bestückungsautomaten angeboten, die meist nach dem "Pick-and-Place"-Verfahren arbeiten. Dies besagt, daß Bauelemente einzeln aufgenommen, zentriert und positioniert und auf die Leiterplatte einzeln aufgesetzt werden. Ein derartiger Vorgang wird für jedes einzelne Bauelement durchgeführt.

Andere Geräte, die auf dem Markt erhältlich sind, weisen bereits einen Vielfachkopf auf, der Bauelemente einzeln in einer Sequenz aufnimmt und an einer Stelle der Leiterplatte jeweils einzeln auf diese absetzt. Dazu ist es nötig, daß die Leiterplatte für jedes Bauelement positioniert wird.

Ein weiteres Gerät zum Stand der Technik arbeitet so, daß mehrere Bauelemente aufgenommen werden können, aber einzeln auf der Leiterplatte abgesetzt werden. Dabei wird die Leiterplatte in einer ebenen Koordinatenrichtung für jedes Bauteil einzeln positioniert, während die Ausrichtung bezogen auf die zweite ebene Koordinatenrichtung durch den Träger des Bauelementes durchgeführt wird.

Diese bekannten Bestückungsautomaten und die zugehörigen Verfahren benötigen entweder sehr lange Zeiten durch die für jedes Bauelement nötigen Transportwege von einer Zuführeinheit zur Leiterplatte und wieder zurück. Auch der Einsatz von Vielfachköpfen ist mit keiner wesentlichen Zeiteinsparung verbunden, da bisher für die Plazierung eines jeden Bauelementes die Leiterplatte bewegt und positioniert werden muß. Weiterhin werden hier die Vorteile eines Vielfachkopfes nicht vollständig ausgenutzt, da die Bauteile teilweise in Sequenzen aufgenommen werden und somit immer eine bestimmte Reihenfolge einzuhalten ist.

Der Erfindung liegt die Aufgabe zugrunde, eine Vorrichtung und ein Verfahren zum Bestücken von Leiterplatten mit Bauelementen bereitzustellen, wobei über eine Mehrfachaufnahme von Bauelementen aus Zuführeinheiten eine wesentlich schnellere Bestückung von Leiterplatten mit gleichzeitiger Ausrichtung und Prüfung der Bauelemente auf richtige Montage und Funktionsfähigkeit, ermöglicht wird.

Die Lösung dieser Aufgabe wird durch eine Vorrichtung ermöglicht, deren Merkmale im kennzeichnenden Teil des Anspruches 1 wiedergegeben sind, sowie durch ein Verfahren, dessen Merkmale im kennzeichnenden Teil des Anspruches 5 beschrieben ist.

Der Erfindung liegt die Erkenntnis zugrunde, daß eine wesentliche Zeiteinsparung bei den Bearbeitungsvorgängen innerhalb eines SMD-Bestückautomaten nur durch den Einsatz eines Mehrfachbestückkopfes erreicht werden kann, wobei am Mehrfachbestückkopf ein Geräteträger befestigt ist, der mittels Bearbeitungsstationen für eine Zentrierung, für Kontaktierung, Messung und beispielsweise für eine Elimination von funktionsunfähigen Bauelementen sorgt, so daß während der Bestückung der Leiterplatte mit einem bestimmten Bauteil andere, gleichzeitig am Mehrfachbestückkopf befindliche Bauelemente gleichzeitig montagefertig bearbeitet werden können. Der Geräteträger ist beispielsweise mit der Halterung des drehbaren Mehrfachbestückkopfes fest verbunden, so daß sich der Mehrfachbestückkopf in Bezug auf den Geräteträger bewegen kann. Beide Apparateteile sind auf einem Schlitten in X-, Y-Richtung verfahrbar, so daß weder zur Aufnahme von Bauelementen aus bestimmten Zuführeinheiten noch zur Bestückung der Leiterplatten mit Bauelementen die Zuführeinheiten noch die Leiterplatten bewegt werden müssen. Dies hat den besonderen Vorteil, daß gegenüber einem "Pick-and-Place"-Gerät nicht zwischen jeweils zwei Bauelementen eine Bewegung des Bestückkopfes von den Zuführeinheiten zur Leiterplatte und zurück nötig ist. Des weiteren kann eine erfindungsgemäße Vorrichtung Bauelemente unabhängig von einer Sequenz sammeln und diese Bauelemente ebenso unabhängig von einer bestimmten Reihenfolge auf der Leiterplatte positionsgenau aufsetzen.

Eine vorteilhafte Ausgestaltung der Erfindung sieht vor, daß zwei nebeneinander auf einem gemeinsamen Stativ einzeln verfahrbare Mehrfachbestückköpfe wechselweise den Vorgang des Sammelns und den Vorgang des Bestückens ausführen. Auch hierbei werden mehrere Taktzeiten für die Transportwege zwischen Zuführeinheit und Leiterplatte eingespart.

Eine vorteilhafte Variante der Erfindung zeigt eine Anordnung, bei der mindestens zwei gegenüberliegende und auf unterschiedlichen Stativen verfahrbare Mehrfachbestückköpfe eine in der Mitte befindliche Leiterplatte mit Bauelementen aus jeweils für die entsprechenden Mehrfachbestückköpfe vorgesehenen Zuführeinheiten bestückt. Ein Vorteil dieser Ausführung liegt darin, daß für jeden Mehrfachbestückkopf eine größere Freiheit für die Bewegung in X-Richtung vorhanden ist, im Gegensatz zu den Bewegungsmöglichkeiten von zwei auf einem Stativ befindlichen Mehrfachbestückköpfen.

Das mit der erfindungsgemäßen Vorrichtung verbundene Verfahren zum Bestücken von Leiterplatten mit Bauelementen sieht vor, daß ein wahlfreies Sammeln von Bauelementen mit anschließendem Bestücken der Leiterplatte mit diesen Bauelementen aus bzw. auf ortsfesten Zuführeinheiten und Leiterplatten geschieht. Dies hat den besonderen Vorteil, daß zum einen zwar Sequenzen von Bauelementen möglich sind, jedoch auf keinen Fall nötig und somit eingehalten werden müßten. Weiterhin kann die Bereitstellung von Bauelementen mittels der ortsfesten Zuführeinheiten wesentlich vereinfacht werden, weil eine Auswechslung derartig ortsfester Einheiten in einfacher Weise vorzunehmen ist. Die Ausrichtung eines Bauelementes in bezug auf seinen Einbauplatz auf der Leiterplatte geschieht über der ortsfesten Leiterplatte durch Verfahren des Mehrfachbestückkopfes auf einem Schlitten in X- und in Y-Richtung. Dies hat den Vorteil, daß lediglich eine Seite, da die Leiterplatte ortsfest ist, ausgerichtet werden muß.

Eine besondere Ausgestaltung der Erfindung ermöglicht es, die in den Zuführeinheiten bereitgestellten Bauelemente ohne vorherige Prüfung und reproduzierbare Positionierung zu liefern. Nach dem Sammeln von Bauelementen aus Zuführeinheiten durch einen Mehrfachbestückkopf wird durch getaktetes Vorbeilaufen der einzelnen am Mehrfachbestückkopf befindlichen Bauelemente an den Bearbeitungsstationen während des Sammelns bzw. während des anschließenden Bestückens dafür gesorgt, daß die Bauelemente zentriert, kontaktiert, elektrisch, optisch oder mechanisch gemessen und eventuell bei Funktionsunfähigkeit aussortiert werden.

Beim Einsatz nur einer Vorrichtung zum Bestücken von Leiterplatten mit Bauelementen, also eines Mehrfachbestückkopfes ist es sinnvoll, zur Zeitersparnis das Sammeln von Bauelementen und den Leiterplattenwechsel gleichzeitig durchzuführen.

Durch den Einsatz einer Codierung der Bauelemente, so daß diese an jeder Stelle der Vorrichtung identifiziert werden können, kann unter Zuhilfnahme von Kameras, über die die Codierung erkannt wird, eine weitere wesentliche Beschleunigung des gesamten Verfahrens erzielt werden.

Wird die erfindungsgemäße Vorrichtung mit einer freiprogrammierbaren Steuerung kombiniert, so ist es möglich, die einzelnen Verfahrensschritte, wie zeitparalleles Arbeiten von mehreren Mehrfachbestückköpfen, Einsatz von verschiedenen Größen verschiedener Saugpipetten, Zuordnung von bestimmten Zuführeinheiten, zum momentanen Aufenthaltsort eines daraus entnommenen Bauelementes und Bestimmungsort des Bauelementes auf der Leiterplatte, sowie Positionierung des Mehrfachbestückkopfes mit dem entsprechend positionierten Bauelemente bezüglich der Leiterplatte und Absetzen des montagefertig geprüften und ausgerichteten Bauelementes auf die Leiterplatte, zu steuern und zu kontrollieren.

Im folgenden wird anhand von schematischen Zeichnungen ein Ausführungsbeispiel beschrieben.

Fig. 1 zeigt die Seitenansicht einer erfindungsgemäßen Vorrichtung mit einem Mehrfachbestückkopf 2 und einem zugehörigen Geräteträger 7.

Fig. 2 zeigt eine Vorrichtung mit einem über den Schlitten 6 am Stativ 9 verfahrbaren Merhfachbestückkopf 1 mit der Relativlage zu den Zuführeinheiten 4 und der Leiterplatte 5.

Fig. 3 zeigt eine Vorrichtung entsprechend der in Fig. 2 gezeigten in der Draufsicht.

Fig. 4 zeigt einen Mehrfachbestückkopf 1 mit dem dazugehörigen Geräteträger 7 und den Bearbeitungsstationen 8 in der Frontalansicht.

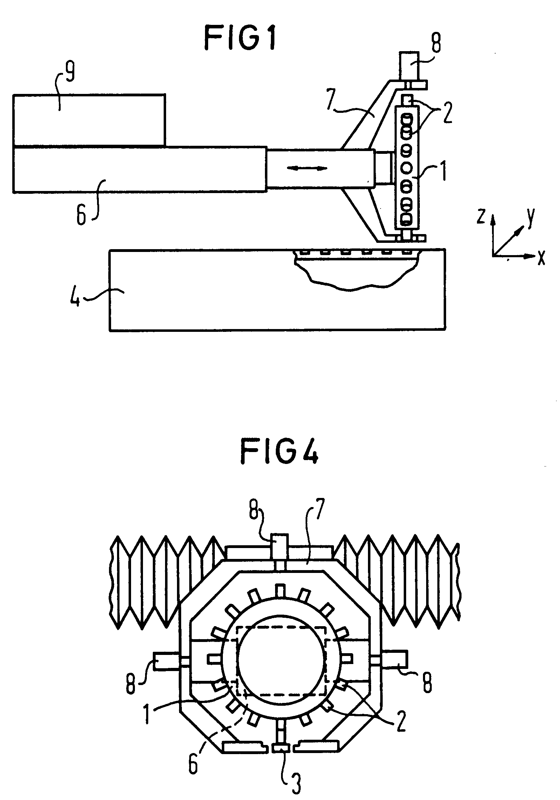

In der Fig. 1 ist in der Seitenansicht der drehbare Bestückkopf 1 mit gleichmäßig darauf verteilten Saugpipetten, die zum Aufnehmen oder Absetzen eines Bauelementes 3 ausfahrbar sind, sowie der Geräteträger 7 mit den darauf befestigen Bearbeitungsstationen 8 sichtbar. Diese Einheit ist auf einem Schlitten 6, der an einem Stativ 9 befestigt ist, in X-, Y-Richtung verfahrbar. Des weiteren ist eine Zuführeinheit 4, die beispielsweise Bauelemente über einen Taschengurt zuführt, angedeutet. Der Mehrfachbestückkopf 1 kann aus mehreren hintereinander liegenden Zuführeinheiten 4 wahlfrei Bauelemente verschiedener Größe und verschiedener Ausrichtung über die Saugpipetten 2, die auch verschiedene Größen haben können, entnehmen, also den Sammelvorgang durchführen, wobei in Anschluß daran eine Zentrierung, Kontaktierung, Prüfung der aufgenommenen Bauelemente 3 mittels der Bearbeitungsstationen 8 durch drehen des Mehrfach-Bestückkopfes 1 in beliebige Richtung vorgenommen werden kann. Der Mehrfach-Bestückkopf 1, der hier sternförmig ausgebildet ist, kann ebenso kreisförmig oder kegelförmig konstruiert sein. Eine kreisförmige Ausbildung würde bedeuten, daß die Saugpipetten ebenfalls auf dem Umfang des Mehrfach-Bestückkopfes verteilt sind, jedoch parallel zur Achse des Mehrfach-Bestückkopfes liegen. Eine kegelförmige Konstruktion hat beispielsweise die Achse des Kegels, der den Mehrfach-Bestückkopf darstellt, unter 45° geneigt, wobei die jeweils senkrecht nach unten zeigende Saugpipette ein Bauelement entnehmen oder Aufsetzen kann. Bei diesen verschiedenen Ausführungsformen muß dafür gesorgt werden, daß die Bearbeitungsstationen 8 innerhalb des Geräteträgers 7 so positioniert sind, daß sie jeweils gegenüber von einer Saugpipette 2 mit einem Bauelement 3 zum Liegen kommen und entsprechend einen Bearbeitungsschritt durchführen können.

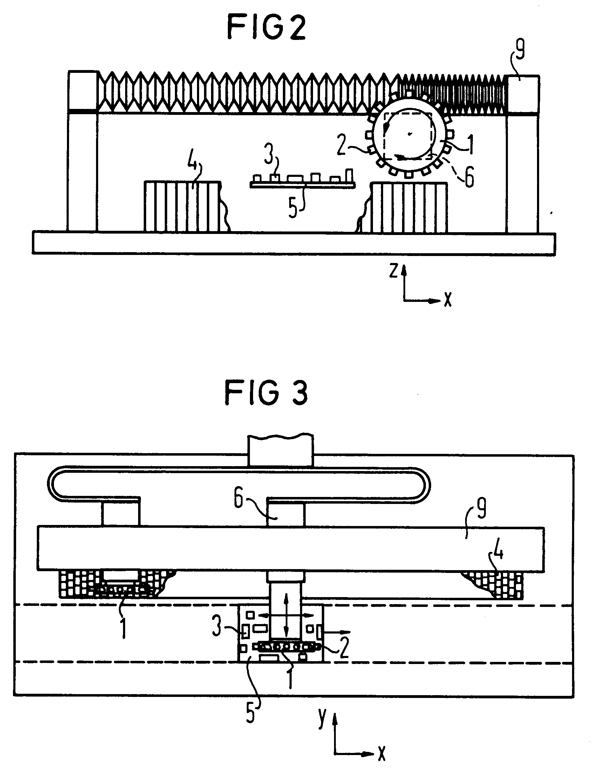

In der Fig. 2 ist eine erfindungsgemäße Anordnung in der Frontalansicht gezeigt, wobei der Schlitten 6 durch eine gestrichelte Linie angedeutet ist. Der Schlitten 6 ist mit bewegbaren Teilen, die durch einen Faltenbalg verdeckt sind auf dem Stativ 9 in X-Richtung fahrbar aufgehängt. Die Verfahrbarkeit des Mehrfachbestückkopfes 1 in $\gamma$-Richtung steht in diesem Fall senkrecht auf der Zeichenebene. Es ist eine Leiterplatte 5 angedeutet, die mit Bauelementen 3 verschiedener Größe und verschiedener Lage versehen ist. In diese Ausführung, die nur einen Mehrfachbestückkopf enthält, wird der Sammelvorgang und der Bestückvorgang von diesem einen vorgenommen. Dabei ist die Drehrichtung des Mehrfachbestückkopfes 1, die durch Pfeile angedeutet ist, durch die freiprogrammierbare Steuerung entsprechend ansteuerbar. Durch die Codierung der Bauelemente 3 ist eine Zuordnung eines bestimmten Bauelementes, das von einer Saugpipette 2 aufgenommen wurde, zu seiner Entnahmeeinheit und zu seiner Bestimmungsposition auf der Leiterplatte 5, sowie in Bezug auf die verschiedenen Bearbeitungsstationen 8, die in dieser Fig. 2 nicht eingezeichnet sind, möglich.

Die Fig. 3 zeigt eine erfindungsgemäße Anordnung, in der zwei Schlitten 6 mit entsprechenden Mehrfachbestückköpfen 1 auf einem gemeinsamen Stativ 9 verfahrbar sind. Es ist angedeutet, daß ein Mehrfachbestückkopf 1 das wahlfreie Sammeln von Bauelementen in Zuführeinheiten 4 durchführt und der andere Mehrfachbestückkopf 1 gleichzeitig das Bestücken der Leiterplatte 5 ausführt. Die möglichen Bewegungsrichtungen des Mehrfachbestückkopfes 1 sind wiederum durch Pfeile angedeutet, die Leiterplatte 5 wird in der Regel in einer Richtung an der Vorrichtung vorbeigeführt, ist jedoch zum Zeitpunkt des Bestückens ortsfest.

Die Fig. 4 zeigt die Frontalansicht eines Mehrfachbestückkopfes 1 mit zugehörigem Geräteträger 7, mit in diesem Falle drei Bearbeitungsstationen 8, mit Saugpipetten 2 und einem Bauelement 3. Die ringförmige Konstruktion des Geräteträgers 7, die hier in Form eines Achteckes gewählt wurde, ermöglicht es, insgesamt sieben bis acht Bearbeitungsstationen 8 aufzunehmen. Durch anderweitige Konstruktionen kann eine Vielzahl von Bearbeitungsstationen 8 eingesetzt werden, die jedoch maximal der Anzahl der Saugpipetten 2 entsprechen kann, die auf dem Mehrfachbestückkopf 1 vorhanden sind. Außerdem ist eine Position einer Saugpipette, nämlich die die senkrecht nach unten zeigt und ein Bauelement, das montagefertig vorbereitet ist, Absetzen kann, nicht mit einer Bearbeitungsstation 8 zu kombinieren.

Ähnlich wie in der Fig. 3 angedeutet, kann eine erfindungsgemäße Vorrichtung nicht nur aus zwei nebeneinander verfahrbaren, sondern auch als zwei gegenüber, in diesem Fall aber auf zwei verschiedenen Stativen verfahrbaren Mehrfachbestückköpfen 1 bestehen, die die gleiche Leiterplatte 5 wechselweise bedienen.

Weiterhin ist zu bemerken, daß natürlich von einem Mehrfachbestückkopf 1 auch nur einzelne Bauelemente 3 aufgenommen werden können. Der Mehrfachbestückkopf muß nicht vollständig gefüllt sein, was ein weiterer Vorteil der Verfahrensweise ohne Sequenzbildung ist.

Mit einer erfindungsgemäßen Vorrichtung lassen sich die Bearbeitungszeiten an einem SMD-Bestückautomaten um 40 % verkürzen.

## Patentansprüche

1. Vorrichtung zum Bestücken von Leiterplatten (5) mit Bauelementen (3), insbesondere bei SMD-Bestückautomaten, mit mindestens einem drehbaren Mehrfach-Bestückkopf (1) mit mehreren Aufnahmewerkzeugen für Bauelemente (3),
   **gekennzeichnet durch,**
   - mindestens einen ringförmigen, um jeweils einen Mehrfach-Bestückkopf (1) angeordneten Geräteträger (7) mit daran befestigten Bearbeitungsstationen (8), wobei sich der Mehrfach-Bestückkopf (1) in Bezug auf die Bearbeitungsstationen (8) drehon kann,
   - die Aufhängung eines oder mehrerer Mehrfach-Bestückköpfe (1) an jeweils einem Schlitten (6), wodurch der Mehrfach-Bestückkopf (1) mit dem zugehörigen Geräteträger (7) in X, Y-Richtung verfahrbar und positionierbar ist.

2. Vorrichtung nach Anspruch 1,
   **gekennzeichnet durch,**
   mindestens zwei nebeneinander auf einem gemeinsamen Stativ (9) einzeln verfahrbare Mehrfach-Bestückköpfe (1).

**3.** Vorrichtung nach Anspruch 1,
**gekennzeichnet durch,**
die Anordnung von mindestens zwei gegenüberliegenden und auf unterschiedlichen Stativen (9) verfahrbaren Mehrfach-Bestückköpfen
(1).

**4.** Verfahren zum Bestücken von Leiterplatten (5)
mit Bauelementen (3) mit einer Vorrichtung
nach einem der vorhergehenden Ansprüche,
**gekennzeichnet durch,**

- wahlfreies Sammeln von Bauelementen
(3) aus Zuführeinheiten (4) mittels mindestens einem Mehrfach-Bestückkopf (1),
- anschließendes Bestücken einer Leiterplatte (5) mit diesen Bauelementen (3),
- zum Zeitpunkt des Sammelns oder Bestückens jeweils ortsfeste Zuführeinheiten (4) und Leiterplatten (5).

**5.** Verfahren nach Anspruch 4,
**gekennzeichnet durch,**
die Bearbeitung der wahlfrei gesammelten
Bauelemente (3) am Mehrfach-Bestückkopf (1)
während des getakteten Vorbeilaufens an den
Bearbeitungsstationen (8).

**6.** Verfahren nach Anspruch 4 oder 5,
**gekennzeichnet durch,**
die gleichzeitige Durchführung von Sammeln
von Bauelementen (3) und Leiterplattenwechsel.

**7.** Verfahren nach einem der Ansprüche 4 bis 6,
**gekennzeichnet durch,**
eine Codierung der Bauelemente, so daß diese
an jeder Stelle der Vorrichtung identifizierbar
sind.

**8.** Verfahren nach einem der Ansprüche 4 bis 7,
**gekennzeichnet durch,**
die Organisation der einzelnen Verfahrensschritte mittels Einsatz einer frei programmierbaren Steuerung.

## Claims

**1.** Device for mounting components (3) on printed
circuit boards (5), preferably in automatic SMD
mounting units, having at least one rotatable
multiple mounting head (1) with a plurality of
tools for receiving components (3), characterised by
- at least one annular device carrier (7),
arranged in each case about a multiple
mounting head (1) and having processing
stations (8) attached thereto, the multiple mounting head (1) being capable of rotating in relation to the processing stations
(8),
- the suspension of one or more multiple
mounting heads (1) on in each case one
carriage (6), by which means the multiple
mounting head (1) can be moved and
positioned with the associated device
carrier (7) in the X and Y directions.

**2.** Device according to Claim 1, characterised by
at least two individually movable multiple
mounting heads (1) next to one another on a
common stand (9).

**3.** Device according to Claim 1, characterised by
the arrangement of at least two multiple
mounting heads (1) located opposite one another and movable on different stands (9).

**4.** Process for mounting components (3) on printed circuit boards (5) with a device according to
one of the preceding claims, characterised by
- optional collecting of components (3)
from feeder units (4) by means of at
least one multiple mounting head (1),
- subsequent mounting of these components (3) on a printed circuit board (5),
- feed units (4) and printed circuit boards
(5) which are stationary in each case at
the time of the collection or mounting.

**5.** Process according to Claim 4, characterised
by the processing of the optionally collected
components (3) on the multiple mounting head
(1) during the clocked passage past the processing stations (8).

**6.** Process according to Claim 4 or 5, characterised by the simultaneous execution of the
collecting of components (3) and changing of
the printed circuit board.

**7.** Process according to one of Claims 4 to 6,
characterised by an encoding of the components so that they can be identified at each
point on the device.

**8.** Process according to one of Claims 4 to 7,
characterised by the organisation of the individual process steps by using a freely programmable control.

## Revendications

**1.** Dispositif pour équiper des plaquettes à circuits imprimés (5) avec des composants (3),
notamment dans le cas d'automates d'équipement du type SMD, comportant au moins une tête d'équipement rotative multiple (1) possédant plusieurs outils de réception pour des composants (3), caractérisé par

- au moins un support annulaire d'appareil (7) disposé respectivement autour d'une tête d'équipement multiple (1) et auquel sont fixés des postes d'usinage (8), la tête multiple d'équipement (1) pouvant tourner par rapport aux postes d'usinage,
- la suspension d'une ou plusieurs têtes d'équipement multiples (1) sur des chariots respectifs (6), ce qui permet de déplacer et de positionner dans la direction X, Y la tête d'équipement multiple (1) à laquelle est associé le support d'appareil (7).

2. Dispositif suivant la revendication 1, caractérisé par au moins deux têtes d'équipement multiples (1) déplaçables individuellement côte-à-côte sur un statif commun (9).

3. Dispositif suivant la revendication 1, caractérisé par la disposition d'au moins deux têtes d'équipement multiples (1) situées en vis-à-vis et déplaçables sur des statifs (9) différents.

4. Procédé pour équiper des plaquettes à circuits imprimés (5) avec des composants (3) à l'aide d'un dispositif suivant l'une des revendications précédentes, caractérisé par

- une collecte libre de composants (3) à partir d'unités d'amenée (4) à l'aide d'au moins une tête d'équipement muiltiple (1),
- l'équipement ultérieur d'une plaquette à circuits imprimés (5) avec ses composants (3),
- des unités d'amenée (4) et des plaquettes à circuits imprimés (5) étant respectivement fixes à l'instant de la collecte ou de l'opération d'équipement.

5. Procédé suivant la revendication 4, caractérisé par l'usinage des composants (3), collectés selon un choix libre, sur la tête d'équipement multiple (1) pendant le passage cadencé devant les postes d'usinage (8).

6. Procédé suivant la revendication 4 ou 5, caractérisé par l'exécution simultanée de la collecte de composants (3) et le remplacement des plaquettes à circuits imprimés.

7. Procédé suivant l'une des revendications 4 à 6, caractérisé par un codage des composants de sorte que ces derniers peuvent être identifiés en chaque emplacement du dispositif.

8. Procédé suivant l'une des revendications 4 à 7, caractérisé par l'organisation des différentes étapes opératoires moyennant l'utilisation d'une unité de commande librement programmable.

FIG 1

FIG 4

# FIG 2

# FIG 3